# EUROPEAN PATENT APPLICATION

(11) **EP 4 832 433 A1**
(43) Date of publication of application: **28.10.2026**
(21) Application number: 25171775.7
(22) Date of filing: 22.04.2025
(51) Int. Cl.: H04L 41/0631, H04L 41/0677, G01R 31/08, G01R 19/25, H04L 41/14, H04L 41/12, H04L 41/0654

(54) **METHODS FOR POWER OUTAGE INFERENCE AND MANAGING POWER DISTRIBUTION SYSTEMS**

(71) Applicant: Hitachi Energy Ltd, 8050 Zürich (CH)
(72) Inventor: CHMIELOWIEC, Krzysztof, 32-089 Beblo (PL); KNEZOVIC, Katarina, 8006 Zurich (CH); WANG, Zhenyuan, Apex, 27502 (US); BOMBA, Piotr, 26-400 Lipno (PL); EKOMWENRENREN, Etinosa, Longueuil, J4K 4Y6 (CA); SHIRSAT, Ashwin, Apex, 27523 (US); SHCHETININ, Dmitry, 5600 Lenzburg (CH)
(74) Representative: Valea AB

(57) **Abstract**

The present invention relates to a method and system (1000) for identifying potential problem locations within a power distribution system and managing network model updates. In a first aspect there is proposed a method which identifies problematic protection devices involving: receiving (101) trouble reports; marking (102) problematic loads; performing a first set of operations (103) and based on results therefrom, marking (104) protection device as problematic; and, performing a second set of operation (106). In a second aspect there is provided a system (1000) comprising interfaces (1010, 1040), memory (1020), and processing means (1030) configured therefor. In third and fourth aspects, methods manage updates to the directed network model upon receiving edge removal (201) or addition (301) requests, respectively; these methods involve updating (203, 304a, 304b) the model topology and specifically re-identifying (204a, 205a, 305a, 306a) loop edges and source edges using graph traversal techniques to maintain model integrity for subsequent technical analysis.

## Description

### FIELD OF THE INVENTION

The present invention relates generally to the field of electric power distribution systems management. More specifically, it pertains to methods and systems for determining the location of faults within a power distribution network based on received outage indications, a process commonly referred to as power outage inference. The invention further relates to the efficient processing and maintenance of network models used in such inference processes, particularly concerning dynamic topological changes and computational efficiency.

### BACKGROUND

Modern electric power distribution utilities increasingly rely on sophisticated Outage Management Systems (OMS) to monitor network status, manage disruptions, and expedite service restoration following power outages. These systems aim to enhance grid reliability and minimize customer impact. To achieve this, OMS integrates data from various sources, including Geographic Information Systems (GIS) providing network topology, Advanced Metering Infrastructure (AMI) which may provide "last gasp" messages upon power loss (see, e.g., US 9,103,854 B2), and potentially other sensor data from Internet of Things (IoT) devices deployed within the network.

A significant data source, particularly in areas lacking comprehensive real-time monitoring infrastructure, remains customer-initiated communications, such as phone calls, reporting a perceived power outage. These reports, alongside automated signals like last-gasp messages, are collectively termed "trouble reports" herein.

A core function within many OMS is power outage inference. This process analyses incoming trouble reports in conjunction with a model of the power distribution network to hypothesize the location of a protection device (e.g., a fuse, circuit breaker, or recloser) whose operation (e.g., tripping or blowing) is the likely cause of the reported outages. Accurate and timely inference is critical for efficiently dispatching repair crews to the correct location, thereby reducing outage duration. US 9,103,854 B2, for instance, discloses managing AMI outage data within an OMS, including filtering last-gasp messages if an outage is already known, to preserve OMS capacity. US 2018/0218584 A1 focuses on proactively managing outage alert communications to customers based on smart meter data. US 8,040,812 B1 describes identifying outage sites by comparing scheduled site lists with actual communication data from gateways.

The network model used for inference is often a simplified topological representation, and is commonly referred to as an "Outage Graph", or when the representation also indicates the direction of power flow: "directed network model". The network model typically includes nodes representing power sources or loads (or aggregations thereof), and edges representing the electrical lines or protection devices between these elements. The inference algorithm generally involves traversing a directed network model, typically upstream from the locations associated with trouble reports towards the power source(s), to identify candidate protection devices whose operation would de-energize the reporting loads.

However, existing outage inference methodologies face several challenges, particularly as distribution networks evolve and incorporate more complex configurations.

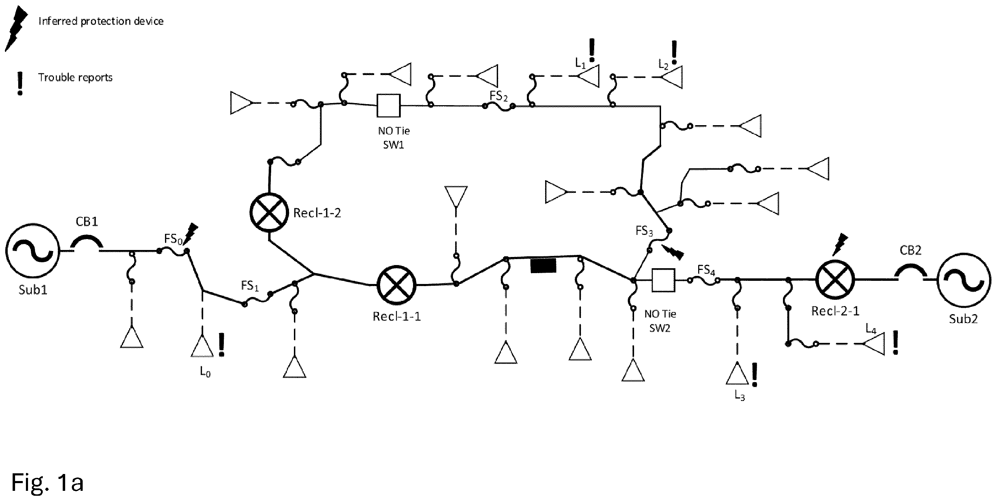

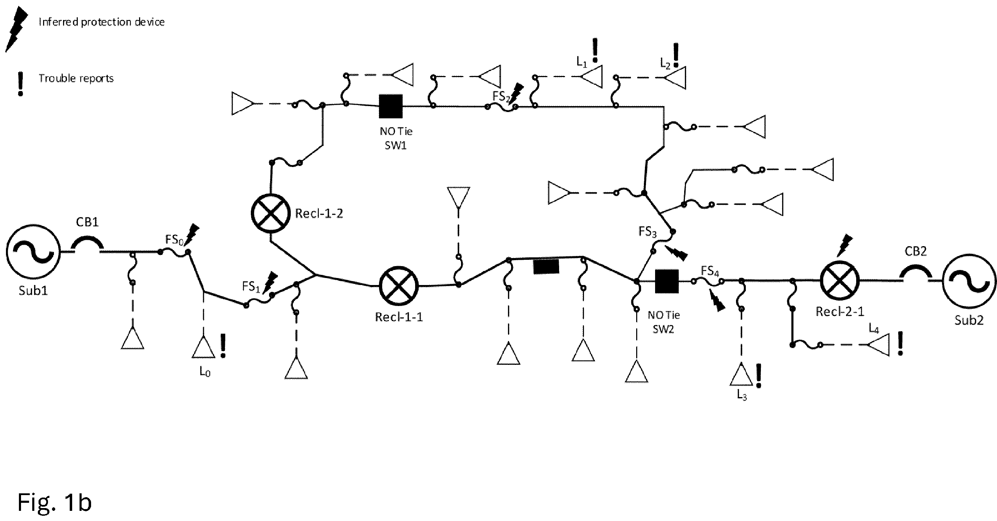

Firstly, the robustness of the inference algorithm itself is a concern. Simple upstream traversal algorithms, often employed in outage inference, may fail or produce ambiguous or incorrect results when the directed network model representing the power distribution network contains cycles (characteristic of meshed or looped network sections) or when the network is supplied by multiple power sources. Handling such complex topologies effectively requires more sophisticated graph analysis capable of accounting for multiple potential fault current paths and supply sources. This challenge is illustrated by comparing a simple, single-sided radial network configuration, depicted schematically in FIG. 1a, with a more complex double-sided, meshed network configuration, depicted schematically in FIG. 1b. The critical dependence of the inference outcome on the network topology is highlighted by the fact that the same set of input trouble reports can lead to markedly different inferred locations for the upstream protective device responsible for the outage, depending solely on whether the network segment is radial or meshed. Such topology-dependent variations in inference outcomes underscore the limitations of basic traversal algorithms. An illustrative example of such differing inference results is presented in Table 1 below:

| Outage case | Trouble reports origin | Inferred protection device | |
|---|---|---|---|
| | | Single-sided, radial network (Fig. 1a) | Double-sided, meshed network (Fig. 1b) |
| 1 | L₀ | FS₀ | FS₀, FS₁ |
| 2 | L₂, L₁ | FS₃ | FS₂, FS₃ |
| 3 | L₃, L₄ | Recl-2-1 | FS₄, Recl-2-1 |

Secondly, achieving the required robustness, for example by incorporating algorithms to detect and handle cycles within the directed network model, often necessitates computationally intensive pre-processing steps before inference can commence. Furthermore, the topology of a power distribution network is not static. Operational actions, such as the opening or closing of tie switches or sectionalizers (e.g., "Tie SW1", "Tie SW2" in FIG. 1), dynamically alter the network configuration and thus the structure of the corresponding directed network model. Reflecting these changes in the directed network model using conventional methods often requires regenerating and re-pre-processing the graph, introducing significant computational overhead and potential delays in the outage management workflow. There is a need for methods that can update the directed network model efficiently in response to topological changes without requiring complete reconstruction and reprocessing.

Thirdly, during widespread disturbances affecting large parts of the network, a high volume of trouble reports may be generated concurrently. Processing these reports serially can lead to unacceptable delays in identifying fault locations and initiating restoration. Therefore, the ability to process outage information, potentially involving parallel execution of inference tasks, is becoming increasingly important for maintaining required operational performance levels.

Consequently, there is a need in the art for improved methods and systems for power outage inference that exhibit enhanced robustness, particularly for complex network topologies including meshed configurations and multiple sources. There is also a need for computationally efficient methods for generating, pre-processing, and dynamically updating the underlying directed network model used for inference, minimizing delays associated with both initial setup and responses to network topology changes. Furthermore, methods facilitating efficient, potentially parallel, processing of large numbers of trouble reports are desirable.

### SUMMARY

The present disclosure addresses limitations in existing Outage Management Systems (OMS) concerning the robustness, computational efficiency, and scalability of power outage inference, particularly for complex power distribution network topologies including meshed configurations and multiple supply sources.

### First aspect

According to a first aspect, there is provided a method performed by a network node. The method comprises receiving trouble reports, wherein each trouble report comprises a unique load identification code representing a load in a power distribution system.

For each trouble report received, the method proceeds by marking the load identification code associated therewith as experiencing a power distribution problem, and adding said marked load identification code to a first dedicated queue Q1.

A first set of operations is subsequently performed for each marked load identification code present in the first dedicated queue Q1. This first set of operations comprises retrieving at least one unique protection device identification code, each such code representing a protection device located nearest the marked load identification code in any given direction upstream therefrom, as determined with reference to a directed network model reflecting the topology of the power distribution system. Furthermore, for each unique protection device identification code thus retrieved, the method involves storing the marked load identification code in a first set, S1, which is associated with the retrieved protection device identification code.

The network node then marks a protection device identification code as experiencing a power distribution problem if the protection device identification code fulfills a predetermined criteria set. The criteria set is related to at least the first set S1 associated with the protection device identification code.

The proposed method further comprises adding a protection device identification code marked as experiencing a power distribution problem to a second dedicated queue Q2, for subsequent processing. A second set of operations is then performed for each marked protection device identification code present in the second dedicated queue Q2. This second set of operations comprises retrieving at least one unique protection device identification code representing a protection device located nearest the marked protection device identification code (from Q2) in any given direction upstream therefrom, again as seen in the directed network model. For each unique protection device identification code retrieved during this second set of operations, the method involves storing the marked protection device identification code (originating from Q2) in the first set, S1, associated with the newly retrieved (further upstream) protection device identification code.

This aspect provides a structured approach for initiating the outage inference process by systematically collecting initial outage indicators (marked load IDs) and associating them with their immediately upstream protection devices within the topological context of the directed network model. The use of a dedicated queue (Q1) and set-based aggregation (S1) facilitates efficient handling and potential parallel processing of incoming trouble reports, thereby enhancing scalability.

Furthermore, the proposed aspect enables an iterative or recursive propagation of the inference process further upstream within the network hierarchy. By processing marked protection devices similarly to marked loads, the method can identify higher-level protection devices whose operation may be the root cause of outages affecting multiple downstream sections, thereby improving robustness in complex, multi-tiered protection schemes.

According to another embodiment, applicable to the first aspect and the preceding embodiment thereof, the first set of operations (and/or the second set of operations, if performed) further comprises associating the marked load identification code (or respectively, the marked protection device identification code) with a first counter, C2. Said first counter C2 indicates the amount (i.e., count) of protection devices and/or loads located nearest the respective marked identification code in any given direction downstream therefrom, as determined from the directed network model. In such embodiments, the predetermined criteria set, used for marking a protection device identification code as experiencing a power distribution problem, is related to both the first set S1 and the first counter C2 associated with that protection device identification code.

The term "nearest" as recited in the above embodiments signifies that the retrieval process identifies the first protection device traversed when traversing along each distinct path leading upstream or downstream from the marked load or marked protection device within the directed network model. Consequently, if multiple topologically distinct upstream paths exist from a given load (as may occur in networked or looped configurations), the set S1 associated with the operation will include the closest protection device identified on *each* of those distinct paths, rather than only the single closest device overall irrespective of path.

The incorporation of the downstream count C2 provides additional topological context to the inference logic. By considering not only the aggregated upstream reports (via S1) but also the downstream network configuration (via C2), the predetermined criteria set can be made more sophisticated, allowing for more accurate differentiation between fault scenarios, thereby enhancing inference precision.

In a further embodiment, the method may additionally comprise, for each received trouble report, adding one count to a trouble report counter, C1, associated specifically with the load identification code contained within that trouble report. Subsequently, the step of marking a load identification code as experiencing a power distribution problem and adding it to the first dedicated queue Q1 is performed conditionally upon the associated trouble report counter C1 having a count that exceeds a predetermined threshold.

This feature introduces a filtering or debouncing mechanism for incoming trouble reports. By requiring multiple reports (or a count exceeding a threshold) for a given load before initiating processing, the method can effectively filter out potentially transient or spurious signals, improving the signal-to-noise ratio and focusing computational resources on more reliably indicated outages, thus enhancing overall system efficiency and reliability.

In certain embodiments implementing the use of both the first set S1 and the first counter C2, the method may further comprise marking a protection device identification code as experiencing a power distribution problem specifically if said protection device identification code is associated with an S1 and a C2 that fulfill at least one condition stipulated within the predetermined criteria set. Exemplary conditions include, but are not limited to: the first set S1 having a cardinality of one, and the first counter C2 having a count equal to one; or, the first set S1 having a cardinality equal to a defined threshold (e.g., an integer greater than one), and the first counter C2 having a count greater than one.

These specific conditions illustrate how the combination of S1 cardinality (reflecting the number of distinct downstream problem reports pointing upstream to the device) and C2 count (reflecting the device's downstream topological significance) can be used to implement nuanced inference rules. Such rules allow the system to distinguish, for example, between a likely fault on a long distribution line protected at various points by protection devices (S1=1, C2=1) and a likely fault on a feeder section supplying multiple branches (S1 >= threshold, C2 > 1), leading to more accurate fault localization.

According to yet another embodiment, the method may further comprise the steps necessary to establish the directed network model itself. This includes retrieving a network model that reflects the topology of the power distribution system, said model comprising a plurality of nodes (representing loads and/or power sources) and edges (representing protection devices and/or power carrying components like lines or transformers connecting nodes). Subsequently, a directed network model is acquired by preprocessing the retrieved network model, such that each edge is assigned a direction indicating the direction of power flow from a power source towards a load represented in the network model. Within this acquired directed network model, the term 'upstream' of a node or edge is defined as pertaining to a node or edge located between a load and at least one power source identified as supplying power to said node or edge, while 'downstream' pertains to a node or edge not so located. It is contemplated that these steps of retrieving, preprocessing, and defining directionality may be performed by the same network node executing the inference steps, or alternatively by a distinct network entity communicatively coupled thereto. This embodiment ensures the availability of the topologically aware, directed graph structure required for the core inference logic.

### Second aspect

According to a second aspect, there is provided an Outage Management System (OMS) for identifying potential problem locations within a power distribution system. The OMS comprises an input interface configured to receive: i) trouble reports, each trouble report comprising a unique load identification code representing a load in the power distribution system, and ii) data representing a directed network model reflecting the topology and power flow direction within the power distribution system. The OMS further comprises a memory configured to store a first dedicated queue (Q1), a plurality of first sets (S1) each associated with a protection device identification code representing protection devices in the power distribution system, and a predetermined criteria set.

Communicatively coupled to the input interface and the memory are processing means. These processing means are configured to execute steps including: receiving said trouble reports via the input interface; for each received trouble report, marking the load identification code associated therewith as experiencing a power distribution problem and adding the marked load identification code to the first dedicated queue (Q1) stored in the memory; performing a first set of operations for each marked load identification code in the first dedicated queue (Q1), said operations comprising retrieving, based on the directed network model, at least one unique protection device identification code representing a protection device located nearest the marked load identification code upstream, and storing, in the memory, the marked load identification code in the first set (S1) associated with the retrieved protection device identification code; marking a protection device identification code as experiencing a power distribution problem if said protection device identification code fulfills the predetermined criteria set stored in the memory, said criteria set being related to at least the first set (S1) associated therewith; and, importantly, generating, based on said marked protection device identification code, an output signal indicative of the identified protection device experiencing the power distribution problem.

Furthermore, the OMS comprises an output interface communicatively coupled to the processing means. This output interface is configured to transmit said output signal for utilization in managing the power distribution system.

This second aspect provides a concrete apparatus embodying the structured inference logic described in the first aspect. By integrating specific input interfaces for acquiring real-world grid status indicators (trouble reports) and topological context (network model), processing means configured for the specific inference steps, dedicated memory structures, and an output interface delivering an actionable result, the OMS ensures the practical implementation and technical application of the inference method within the operational environment of power distribution network management. This facilitates enhanced diagnostic capabilities directly within the system responsible for coordinating restoration efforts.

### Third aspect

According to a third aspect, the present disclosure provides a method for processing a directed network model reflecting the topology of a power distribution system. This aspect particularly addresses the efficient updating of such a model in response to network events signifying topology changes, specifically the removal of an edge representing, for example, the opening of a switch or the failure of a line segment. The method comprises receiving a network event for processing, wherein the event comprises an edge removal request specifying an edge to be removed from the model. The method operates on a retrieved directed network model which reflects the power distribution system's topology, comprising a plurality of nodes (representing loads and/or power sources) and edges (representing protection devices and/or power carrying lines).

The directed network model utilized by this method has been subjected to prior preprocessing. This preprocessing ensures that each edge within the model is assigned a direction indicating the intended or calculated direction of power flow (typically from a source towards a load), thereby establishing unambiguous 'upstream' and 'downstream' relationships relative to any point in the network model. Furthermore, as a result of this preprocessing, specific categories of edges have been identified and marked within the model: namely, 'loop edges', defined as edges belonging to at least one path that starts and ends at the same node without repeating intermediate nodes (i.e., part of a cycle), and 'source edges', defined as edges located on at least one path that interconnects two or more distinct nodes representing power sources within the system.

Upon receiving the edge removal request, the method proceeds by removing the edge associated with said request from the directed network model. Following the removal, the method executes conditional logic based on the pre-identified type of the removed edge. Specifically, if the removed edge was identified as a loop edge in the model prior to its removal, the method performs an operation of adjusting the directions of relevant edges remaining in the directed network model. Conversely, if the removed edge was not identified as a loop edge, the method involves conceptually splitting the directed network model at the location of the removed edge (thereby isolating formerly connected sections) and subsequently adjusting the directions of relevant edges in the affected part(s) of the model. Additionally, if the removed edge was identified as a source edge prior to its removal, the method performs an operation of adjusting the directions of relevant edges remaining in the directed network model.

This third aspect provides a methodology for maintaining the accuracy of the directed network model in response to dynamic topological changes. By leveraging the pre-identified loop and source edge characteristics, the method enables the network node to avoid complete model regeneration and re-preprocessing. This ensures that the directed network model remains a reliable representation of the current network state for use in dependent applications, such as real-time outage inference.

In an embodiment refining the adjustment process performed when the removed edge is a loop edge, the step of adjusting the directions of relevant edges further comprises the following sub-steps. First, from each node that was associated with (i.e., an endpoint of) the removed loop edge, the directed network model is traversed using only those edges currently identified as loop edges. The traversed edges encountered during this traversal are then collected.

Subsequently, a determination is made as to which edges among the collected set of edges still constitute loop edges in the modified topology, and these edges are identified (or re-identified) as such within the directed network model. Finally, the direction of those edges within the collected set that are determined to be no longer part of a loop (i.e., non-looped edges within the affected region) is adjusted to reflect the new, potentially radial, power flow path resulting from the loop break.

In a further embodiment the above determination and adjustment originates from the traversed nodes connected to at least one edge exclusively associated with upstream direction (i.e., not downstream as well as upstream direction). For example, loop edges and source edges associated with both downstream and upstream direction, as such nodes exclusively connected to e.g., loop edges would not be collected as these edges would not be connected to any edge exclusively associated with an upstream direction. To exemplify, consider a scenario wherein a traversed node connects to three edges: two "loop edges" and one single direction edge. In this scenario the network node collects the node that apart from connecting loop edges also connects to single direction edge.

These embodiments ensure accurate and computationally efficient methodology for the recalculation of power flow directions and loop status within a network section immediately following the opening of a loop. By systematically traversing the remaining loop segments and re-evaluating edge types and directions locally, the method correctly updates the model to reflect the altered topology without requiring global analysis, thereby contributing to the efficiency and accuracy of the update process.

In another embodiment, refining the adjustment process performed when the removed edge is a source edge, the step of adjusting the directions of relevant edges further comprises the following sub-steps. First, from each node that was associated with the removed source edge, the directed network model is traversed using only those edges currently identified as source edges. This traversal continues until either a node representing a power source or a non-looped source edge is reached. The traversed edges and nodes encountered during this restricted traversal are collected. Following collection, the direction of specific collected edges (e.g., those now fed from only one remaining source path) is adjusted within the model. Furthermore, a determination is made as to which edges among the collected set continue to form a path between relevant end nodes (such as the remaining interconnected power source nodes), and these edges are identified (or re-identified) as source edges within the updated directed network model.

This embodiment provides a computationally efficient methodology for handling the topological and flow direction changes resulting from the severance of an interconnection between power sources. It ensures that the model correctly reflects the new supply paths and updates the identification of edges critical to understanding the multi-source configuration, preserving the model's integrity for applications sensitive to power source arrangements and associated fault current paths. This embodiment allows for the method to correctly update the model to reflect the altered topology without requiring global analysis, thereby contributing to the efficiency and accuracy of the update process.

### Fourth aspect

According to a fourth aspect, the present disclosure puts forth a method for processing a directed network model reflecting the topology of a power distribution system, focusing specifically on the efficient handling of updates resulting from a network event comprising an edge addition. Such an event may correspond, for instance, to the closing of a normally open tie switch or the integration of a new power line segment into the network. The method commences upon receiving such a network event, which includes an add edge request specifying the unique identification codes (IDs) of two nodes within the system that are intended to be connected by the new edge.

The method then proceeds to retrieve at least one directed network model deemed pertinent to this request, specifically targeting any model(s) that already contain at least one of the two nodes specified in the request. Any directed network model retrieved reflects the system's topology (comprising nodes for loads/sources and edges for lines/devices) and, importantly, has undergone prior preprocessing. This preprocessing ensures that each edge within the model possesses an assigned direction indicative of power flow (establishing 'upstream' and 'downstream' definitions) and that 'loop edges' (edges forming part of a cycle) and 'source edges' (edges forming part of a path interconnecting distinct power sources) have been previously identified and appropriately marked within the model structure.

The subsequent course of action is conditional upon the outcome of the retrieval step. If the retrieval operation yields two distinct directed network models (implying that the two nodes specified for connection resided in previously separate, electrically isolated sections of the modeled network), the method first merges these two models into a single, unified directed network model. Following this merge, the new edge is added to connect the two specified nodes within this now unified model. Alternatively, if the retrieval operation yields only one directed network model (indicating the two nodes were already part of the same modeled electrical section), the method proceeds directly to add the new edge, connecting the two specified nodes within that existing model.

The method includes processing steps designed to identify newly created loop edges. Concurrently or subsequently, the method includes processing steps designed to identify newly created source edges.

This fourth aspect enables for an efficient and structured approach for updating the directed network model when network connectivity is increased via edge addition. It correctly handles scenarios involving the joining of previously disconnected network sections through model merging and employs targeted post-addition processing to identify only the specific edges whose status changes (becoming loop or source edges) as a direct result of the addition.

In an embodiment that elaborates on the processing performed to identify new loop edges consequent to the edge addition, these steps comprise the following. The directed network model is traversed in the upstream direction, initiating from each of the two nodes connected by the newly added edge. This upstream traversal continues until at least one node designated as a power source is encountered along each path. The edges encountered during these traversals are collected. Based on analysis of this collected set of edges (which implicitly includes the paths leading upstream from the new edge and the new edge itself), a determination is made to ascertain which specific edges within this set now constitute part of one or more newly formed cycles. Finally, those edges determined to be part of such new loops are explicitly identified as 'loop edges' within the data structure of the directed network model.

This embodiment provides a focused technique for detecting loop formation caused by edge addition. By performing limited upstream traversals from the points of connection and analysing the resulting paths, it efficiently identifies the newly cyclic portions of the network without necessitating a full graph traversal or cycle detection across the entire model, thereby contributing significantly to the computational efficiency of the model update process.

In a further embodiment, elaborating on the processing performed to identify new source edges consequent to the edge addition, these steps comprise the following. The directed network model is traversed in the upstream direction, again initiating from each of the two nodes connected by the newly added edge. This upstream traversal proceeds until, along each path, either at least one node designated as a power source is reached, or at least one edge previously identified as a source edge (and which is not simultaneously a loop edge) is encountered. Both the edges encountered during these traversals and the terminal nodes reached at the conclusion of each traversal path (the 'end nodes') are collected. Using exclusively the edges and nodes within this collected set, a determination is made regarding which paths, if any, can now be formed that interconnect the collected end nodes. Finally, every edge that is determined to form part of any such interconnecting path is explicitly identified as a 'source edge' within the directed network model.

This embodiment ensures the accurate identification of new or altered paths between power sources resulting from the edge addition. By tracing upstream connectivity to existing source infrastructure points and analysing the connectivity established within the relevant subgraph defined by the collected elements, the method correctly updates the identification of all edges involved in newly formed source-to-source connections. This avoids computationally expensive global re-analysis of the entire network topology, thereby minimizing update latency and maintaining an accurate model representation suitable for time-sensitive OMS applications.

### Fifth aspect

According to a fifth aspect, the present disclosure provides a system for managing a power distribution system, such as the Outage Management System (OMS). This aspect addresses the need for maintaining an accurate and up-to-date representation of the power distribution network's topology, particularly the status of loop and source interconnections, to ensure the reliability of dependent technical applications even when the network configuration changes dynamically. The system comprises essential hardware components including at least one input interface, a processing means, and a non-transitory memory communicatively coupled.

The core function of the system involves receiving network events via the input interface, specifically requests for edge additions or removals that signify changes in the physical power distribution system's topology. In response to such events, the processing means, executing instructions stored in memory, retrieves or accesses a directed network model reflecting the system topology. Crucially, the processing means processes this model according to the methodologies detailed previously in relation to the third or fourth aspect to update the model structure and, importantly, to re-identify and correctly update the status of loop edges and source edges within the model affected by the topological change. This ensures the directed network model accurately reflects the current state of network connectivity, including potentially complex meshed or multi-source configurations.

Furthermore, in some embodiments, the system is configured not merely to maintain the model but to actively utilize this processed, high-fidelity model for performing substantive technical analyses related to the physical state or operation of the power distribution system. These analyses leverage the accurately re-identified loop and source edge information as critical input. Examples include performing power distribution problem inference (e.g., fault location) by correlating sensor data with topology, simulating the impact of proposed switching operations to ensure safety and predict outcomes, or performing load flow calculations or state estimation for real-time monitoring. The system then generates output data representing the results of these technical analyses, suitable for use in controlling, monitoring, or supporting operational decisions regarding the physical power distribution system. This aspect thus provides a tangible apparatus configured to translate efficient model management into improved technical oversight and control of the power grid.

### BRIEF DESCRIPTION OF DRAWINGS

FIG. 1a illustrates a single-sided radial network configuration.
FIG. 1b illustrates a double-sided meshed network configuration.
FIG. 2a and 2b illustrates embodiments according to the first aspect of the present invention.
FIG. 3 illustrates embodiments according to the third aspect of the present invention.
FIG. 4a and 4b illustrates embodiments according to the third aspect of the present invention.
FIG. 5a and 5b illustrates embodiments according to the fourth aspect of the present invention.
FIG. 6a illustrate a further embodiment according to the third aspect.
FIG. 6b illustrate a further embodiment according to the fourth aspect.

### DETAILED DESCRIPTION

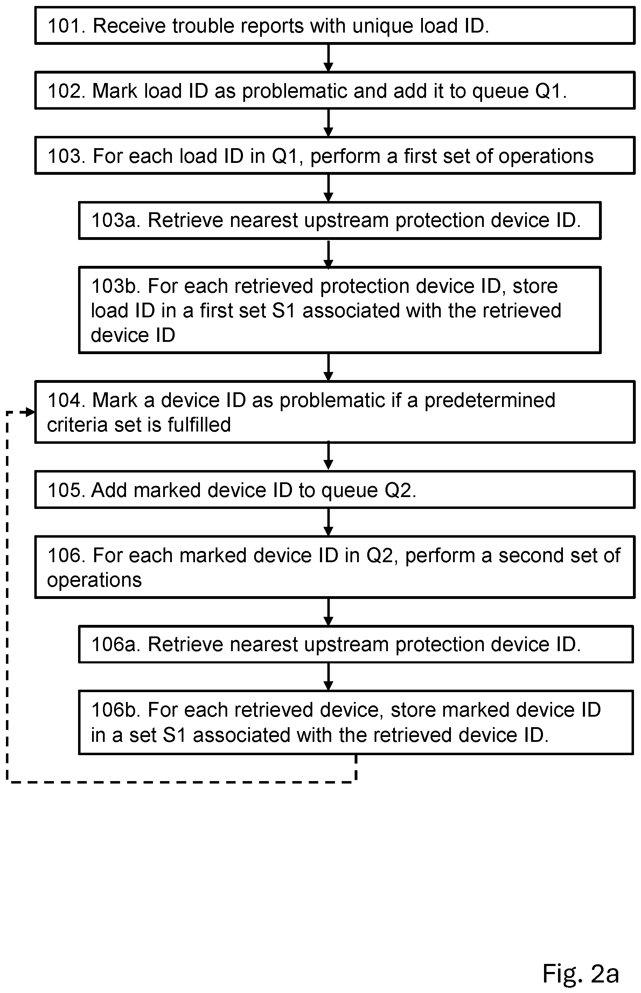

According to a first aspect of the present invention, illustrated in FIG. 2a, there is proposed a method performed by a network node. The method comprises the following steps.

Receiving trouble reports 101. Each trouble report comprises a unique load identification code representing a load in a power distribution system. The load identification code is referred to as *load ID* in the illustrated embodiment and the terms *ID* and *identification code* are used interchangeably in the present description.

Marking 102 the load identification code associated with the trouble report as experiencing a power distribution problem for each received trouble report, and adding the marked load identification code to a first dedicated queue Q1. In the illustrated embodiment, the marking 102 of the load ID as experiencing a power distribution problem is referred to as marking 102 the load ID as problematic. It should be understood that the term problematic in this description thus refers to a component experiencing a power distribution problem.

Performing a first set of operations 103 for each marked load identification code in the first dedicated queue Q1 comprising the steps:
- Retrieving 103a at least one unique protection device identification code each representing a protection device located nearest the marked load identification code in any given direction upstream from the marked load identification code as seen in a directed network model reflecting the topology of the power distribution system.
- For each retrieved protection device identification code: storing 103b the marked load identification code in a first set S1 associated with the retrieved protection device identification code.

Marking 104 a protection device identification code as experiencing a power distribution problem if the protection device identification code fulfills a predetermined criteria set related to at least the first set S1 associated with the protection device identification code.

The "directed network model" is a model establishing the topological context necessary for identifying upstream and downstream protection devices. The network node may comprise the directed network model or it may communicate with a node that comprises said model. In certain embodiments elaborated upon below, the network node may retrieve (e.g., subsequently to receiving 101 the trouble report) the directed network model comprising a plurality of nodes and edges representing the power distribution system so that the network model is made into a directed network model which further represents the direction of power flow in the power distribution system. It should thus be understood that e.g., marking 102 the load ID as problematic or marking 104 a protection device ID might entail adjusting the directed network model to change metadata of the node associated with the load ID or the edge associated with the protection device ID.

The network node preferably retrieves 103a, 106a all identification codes for the protection devices located nearest the marked load identification code in any given direction upstream from the marked load identification code. However, in certain scenarios it might be preferable that some protection device identification codes are not retrieved such as if the protection device ID is associated with a protection device currently under repair / replacement.

The dashed arrow drawn between step 104 and 106b indicates that the network node marks 104 protection device IDs as experiencing a power distribution problem based on the outcome from the first set of operations 103 and the second set of operations 106. In other words, the network node may mark 104 a protection device ID as experiencing a power distribution problem irrespective of what other operations are under processing. This is possible since the marking 104 is performed when the predetermined criteria set is fulfilled. However, as the skilled person understands, the network node may e.g., check if the predetermined criteria set is fulfilled after the first set of operations or the second set of operations. As can be seen in FIG. 2a, the method may further comprise:
Adding 105 the marked protection device identification code to a second dedicated queue Q2 for further processing.

Performing a second set of operations 106 for each marked protection device identification code in the second dedicated queue Q2 comprising the steps:
- Retrieving 106a at least one unique protection device identification code representing a protection device located nearest the marked protection device identification code in any given direction upstream from the marked protection device identification code as seen in a directed network model reflecting the topology of the power distribution system.
- For each retrieved protection device identification code: storing 106b the marked protection device identification code in a first set S1 associated with the retrieved protection device identification code.

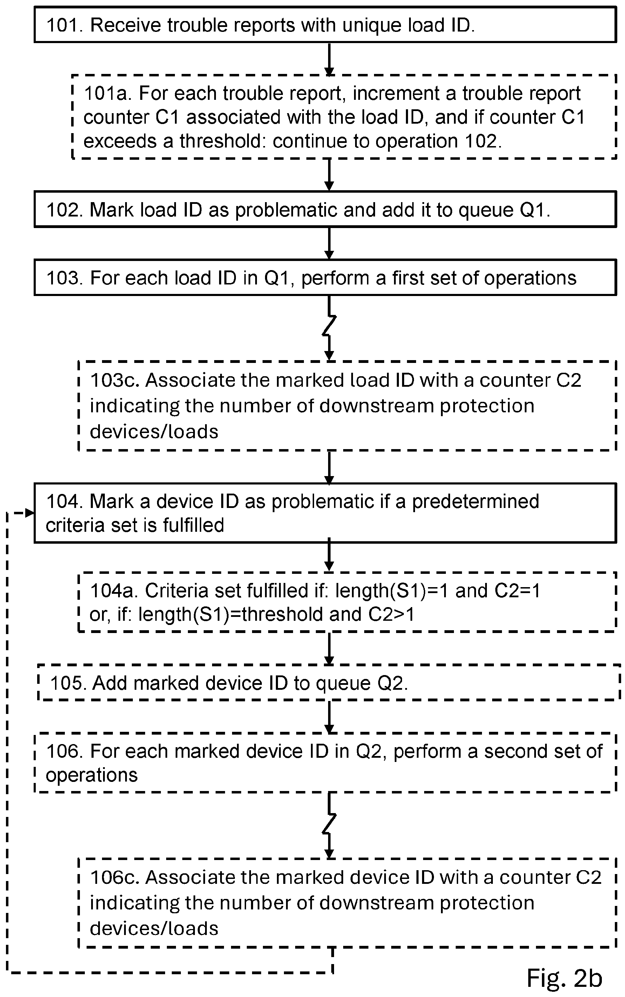

In FIG. 2b there is illustrated further embodiments according to the first aspect. The arrows with a diagonal zigzag near its midpoint indicates that step 103a, 103b respectively step 106a, 106b are not illustrated but may still be performed.

In the illustrated embodiments on FIG. 2b, the first set of operations 103 further comprises:
- associating the marked load identification code 103c with a first counter C2 indicating the amount of protection devices and/or loads located nearest the marked load identification code in any given direction downstream as seen in a directed network model reflecting the topology of the power distribution system.

As can also be seen, the second set of operations 106 further comprises:
- associating the marked protection device identification code 106c with a first counter C2 indicating the amount of protection devices and/or loads located nearest the marked protection device identification code in any given direction downstream as seen in a directed network model reflecting the topology of the power distribution system;

The first counter C2 may be used to determine when a protection device identification code should be marked as experiencing a power distribution problem. Meaning that, the predetermined criteria set may be related to both the first set S1 and first counter C2 associated with the protection device identification code.

It should be understood that either or both of operation 103c and 106c may be performed in embodiments, as well as that operation 103c respectively 106c are not dependent on operation 103a, 103b respectively 106a, 106b. Thus 103c respectively 106c may be performed either prior to or subsequently to, 103a, 103b respectively 106a, 106b.

In one proposed embodiment, as also illustrated in FIG. 2b, the method further includes the operations:
Adding one count 101a to a trouble report counter C1 associated with each load identification code. This operation is performed for each trouble report.

If a trouble report counter is associated with a count above a predetermined threshold, the network node marks 102 the load identification code associated with the trouble report counter as experiencing a power distribution problem and adds the marked load identification code to a first dedicated queue Q1.

In embodiments, the predetermined criteria set may comprise a number of conditions. These conditions may for example relate to metadata associated with a protection device ID.

For example, in one proposed embodiment, which is also illustrated in FIG. 2b, the method further comprises:
Marking 104 a protection device identification code as experiencing a power distribution problem if the protection device identification code is associated with a first set S1 and first counter C2 fulfilling at least one condition of the predetermined criteria set, said conditions being fulfilled 104a when:
- the first set S1 having a cardinality of one, and the first counter C2 having a count equal to one; and/or
- the first set S1 having a cardinality equal to a defined threshold, and the first counter C2 having a count greater than one.

The "defined threshold" referred to herein represents a predetermined numerical value, typically an integer greater than one, which signifies a critical size for the first set S1 when considered in conjunction with the state of the first counter C2. This threshold may be statically configured within the system, for instance, based on empirical data or network topology considerations, or it may be dynamically adjustable based on operational parameters or administrative settings. Its specific value determines the minimum cardinality of S1 required, when C2 exceeds one, to trigger the marking 104.

Furthermore, it is to be understood that the two conditions listed above, relating the cardinality of S1 and the count of C2, are exemplary instances of conditions that may constitute the predetermined criteria set. The set may encompass further or alternative conditions for triggering the marking 104. Such additional conditions could, without limitation, pertain to the rate of change of S1, the specific elements contained within S1, temporal constraints associated with the accumulation of counts or elements, relationships with other counters or sets (not explicitly shown), or other metadata associated with the protection device identification code beyond that directly influencing S1 or C2. The fulfillment of any one or a combination of conditions stipulated within the full predetermined criteria set may suffice to effect the marking 104.

In certain embodiments, the method performed by the network node further comprises operations related to establishing the topological context necessary for identifying upstream protection devices.

Specifically, the network node may perform the steps of:
- Retrieving a directed network model reflecting the topology of the power distribution system, the network model including a plurality of nodes and edges. Each node represents at least one load or power source and each edge represents at least one protection device or a power carrying component (e.g. line or transformer) connecting two nodes. The directed network model having been preprocessed such that each edge is assigned a direction indicating the direction of power flow from a power source towards a load represented in the network model. Within this directed network model, wherein upstream direction of an edge is defined as a direction from at least one load to at least one power source, and wherein downstream direction of an edge is defined as a direction from at least one power source to at least one load.

**In** an alternative embodiment, the network node retrieves an undirected network model, i.e., a network model that has not been preprocessed such that each edge is assigned a direction. **In** such an embodiment the network node may then be configured to preprocess the undirected network model as to create a directed network model.

**In** some embodiments, the operations of retrieving the network model may not be performed by the same network node that performs the steps 101, 102, 103, and 104. Instead, the network topology processing tasks 103, 106 (and potentially 102, 103) may be executed by a separate, distinct network entity, such as a dedicated topology processing server or a central network management system, which is in communication with the network node performing the primary method steps. In such distributed architectures, the network node responsible, for e.g., steps 101-104, would obtain the necessary topological information, specifically the identity of the relevant upstream protection devices for a given load ID as required for e.g., step 103a, from said separate network entity. This communication may, for instance, involve the network node querying the separate entity with a load ID and receiving the corresponding upstream protection device ID(s) in response via a predefined interface or protocol. Alternatively, the separate entity might periodically compute and push updated directed topology information or relevant upstream mappings to the network node, which then stores this information locally for use in e.g., step 103a or 106a.

**In** certain embodiments, the method performed by the network node, as described according to the first aspect and its associated embodiments, is further configured to enhance processing efficiency and throughput, particularly advantageous when dealing with high volumes of trouble reports concurrently or when analysing extensive and complex sections of the power distribution network. This enhancement is achieved through the implementation of parallel execution capabilities for specific operations within the method.

According to one such embodiment, the network node is configured such that the first set of operations 103, which is performed for each marked load identification code retrieved from the first dedicated queue Q1, may be executed in parallel.

Specifically, the processing associated with distinct marked load identification codes present in Q1 need not occur sequentially. The operations comprising retrieving the unique protection device identification codes located nearest upstream 103a for a given marked load identification code, and the subsequent storing 103b of that marked load identification code into the first set S1 associated with each retrieved upstream protection device identification code, can be performed concurrently for multiple marked load identification codes simultaneously or pseudo-simultaneously. The implementation of such parallel execution can leverage various parallel computing paradigms, including but not limited to multi-threading within the network node, utilizing multiple processor cores, or distributing the workload across multiple computing instances, depending on the specific system architecture.

The technical effect of enabling parallel execution for the first set of operations is a significant increase in the processing capacity for incoming trouble reports. This allows the system to more effectively handle bursts of reports, as typically occur during major disturbance events, thereby reducing latency in the initial aggregation of outage evidence at the first upstream protection device level and accelerating the overall response time of the outage management system.

According to another such embodiment, further enhancing the efficiency of the upstream inference propagation, the network node is configured such that the second set of operations 106, performed for items retrieved from the second dedicated queue Q2, may also be executed in parallel.

As previously detailed, the second dedicated queue Q2 serves to hold identification codes, primarily marked protection device identification codes deemed problematic based on the predetermined criteria set 104, for further upstream analysis. The second set of operations 106 involves processing these identification codes by retrieving their respective nearest upstream protection device identification code(s) 106a and storing the originating marked identification code (from Q2) in the first set S1 associated with the newly retrieved upstream protection device(s) (106b).

This parallel execution capability allows the network node to perform this second set of operations concurrently for multiple distinct identification codes present in and dequeued from the second dedicated queue Q2. Thus, the upstream tracing originating from multiple distinct points (marked protection devices) in the network can proceed in parallel. Again, suitable parallel computing techniques known to the skilled person may be employed for implementation.

The technical effect of parallelizing the second set of operations is the acceleration of the inference process, particularly in scenarios involving topologically deep networks requiring multi-level upstream traversal, or when analysing widespread events potentially caused by faults at higher levels in the network hierarchy or multiple simultaneous faults. By concurrently exploring different upstream paths originating from various marked protection devices, the time required to converge on the actual root-cause protection device(s) responsible for the observed outages is substantially reduced, leading to faster and more efficient service restoration efforts.

In one embodiment of the first aspect the method further comprises:
- generating, by the network node and based on said marked protection device identification code, an alert message identifying the protection device marked as experiencing a power distribution problem; and
- transmitting said alert message for display on a graphical user interface associated with an Outage Management System (OMS) configured for monitoring and managing the power distribution system.

In another embodiment of the first aspect the method further comprises:
- generating, by the network node and based on said marked protection device identification code, control data specifying the identified protection device; and
- transmitting said control data to an automated switching system or control interface configured to utilize said control data to perform a switching operation within the power distribution system related to the identified protection device.

In yet another embodiment of the first aspect the method further comprises:
- initiating, by the network node via an interface to an Outage Management System (OMS) and based on said marked protection device identification code, an operational workflow within the OMS, wherein said operational workflow includes procedures for dispatching a repair crew to a geographic location corresponding to the protection device marked as experiencing a power distribution problem.

### Second aspect

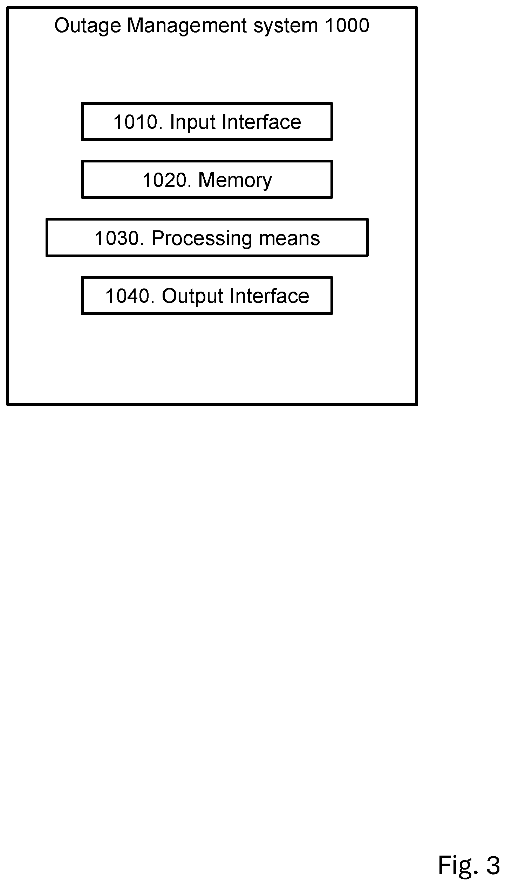

According to a second aspect of the present invention, illustrated conceptually in FIG. 3, there is provided an Outage Management System (OMS) 1000 specifically configured for identifying potential problem locations within a power distribution system, thereby enhancing outage diagnostics.

The OMS 1000 comprises an input interface 1010. This interface is configured to receive data from various sources relevant to the state and structure of the power distribution system. Specifically, it is configured to receive trouble reports, such as those originating from customer calls logged in a Customer Information System (CIS), Automated Metering Infrastructure (AMI) alerts (e.g., 'last gasp' notifications), or SCADA alarms. Each trouble report comprises, or is associated with, a unique load identification code representing a specific load (e.g., a customer meter point or distribution transformer) within the network. The input interface 1010 is further configured to receive data representing a directed network model of the power distribution system, which may be sourced from a Geographic Information System (GIS) or network planning database and preprocessed to create a directed network model.

The OMS 1000 further comprises a memory 1020, which may include volatile and non-volatile storage components. The memory 1020 is configured to store operational data structures required for the inference process, including at least the first dedicated queue (Q1) for holding marked load identification codes awaiting processing, and the plurality of first sets (S1), wherein each set S1 is associated with a unique protection device identification code and stores the marked load identification codes potentially affected by that device. The memory 1020 is also configured to store configuration data, such as the predetermined criteria set used for marking protection devices as problematic, and potentially a local copy or relevant portions of the directed network model. If counters C1 and/or C2 are implemented, the memory 1020 would also be configured to store these counters.

Communicatively coupled to the input interface 1010 and the memory 1020 are processing means 1030. The processing means may comprise one or more processors, microcontrollers, or application-specific integrated circuits (ASICs). The processing means 1030 are specifically configured by software instructions, hardware logic, or a combination thereof, to perform the core inference logic. This configuration includes executing the steps of:
- Receiving the trouble reports via the input interface 1010 (analogous to step 101).
- For each report, marking the associated load **ID** as problematic and adding it to Q1 stored in memory 1020 (analogous to step 102).
- Performing the first set of operations (analogous to step 103) for items in Q1, which involves retrieving upstream protection device IDs using the network model (analogous to step 103a) and storing the initiating load **ID** in the corresponding S1 set in memory 1020 (analogous to step 103b). This may also involve associating counters C2 (analogous to step 103c) if implemented.
- Evaluating protection device IDs against the predetermined criteria set stored in memory 1020, considering at least the associated S1 set (and potentially C2), and marking those fulfilling the criteria as experiencing a power distribution problem (analogous to step 104). This may involve applying specific conditions as detailed in embodiments of the first aspect.
- Crucially, the processing means 1030 are configured to generate, based on identifying a marked protection device identification code, an output signal. This output signal is indicative of the specific protection device identified by the inference logic as being potentially problematic and related to the received trouble reports.

The OMS 1000 also comprises an output interface 1040, communicatively coupled to the processing means 1030. The output interface 1040 is configured to transmit the output signal generated by the processing means 1030. This transmission is directed towards other systems or interfaces where the information can be utilized in managing the power distribution system. Examples of such utilization include, but are not limited to: transmitting the signal to populate a graphical user interface map within the OMS itself, showing the likely faulted device; sending data to a work management system to automatically generate a trouble ticket or work order; providing input to a SCADA system for operator review or potentially initiating automated switching sequences; or logging the inferred result for performance analysis. The provision of this output interface ensures the result of the internal inference process is made available externally in a usable format for tangible actions related to grid operation and restoration.

### Third aspect

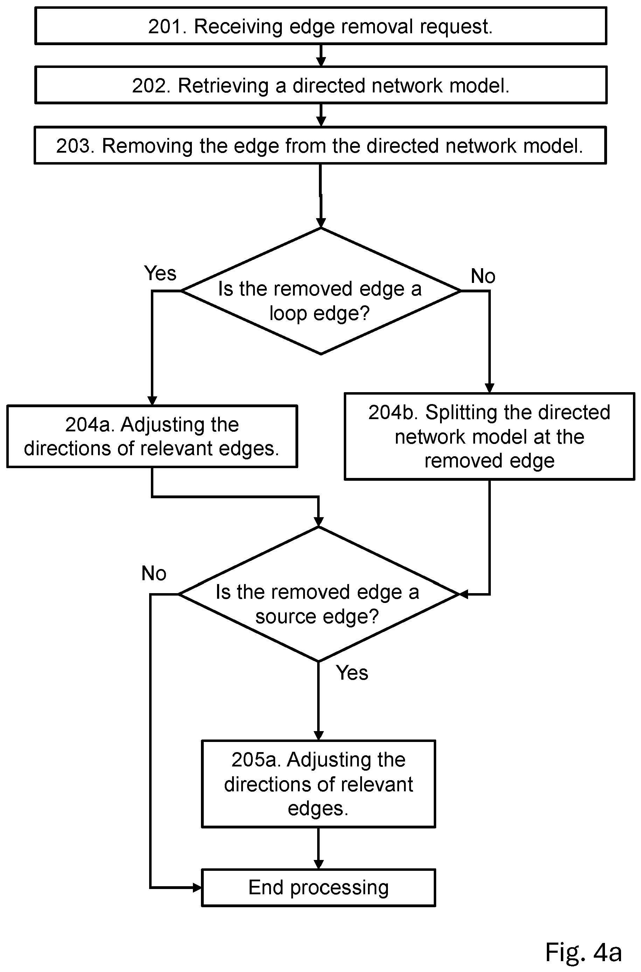

According to a third aspect of the present invention there is proposed a method for processing a directed network model reflecting the topology of a power distribution system. An embodiment according to the third aspect is illustrated in **FIG. 4a** and comprises the following operations:
Receiving **201** a network event for processing comprising an edge removal request.

Retrieving **202** a directed network model reflecting the topology of the power distribution system. The directed network model includes a plurality of nodes and edges. Each node represents at least one load or power source, and each edge represents at least one protection device or a power carrying line connecting two nodes.

The directed network model has been preprocessed such that:
- Each edge is assigned a direction indicating the direction of power flow from a power source towards a load represented in the network model. Upstream direction of an edge is defined as a direction from at least one load to at least one power source, and wherein downstream direction of an edge is defined as a direction from at least one power source to at least one load.
- Loop edges and source edges are identified. A loop edge is an edge in the directed network model identified as belonging to at least one path that starts and ends at the same node without repeating any intermediate nodes. A source edge is an edge that is located on at least one path that interconnects two or more nodes representing power sources within the power distribution system.

Removing **203** the edge associated with the edge removal request from the directed network model.

If the removed edge is a loop edge in the directed network model: the network node adjusts **204a** the directions of relevant edges in the directed network model. However, if the removed edge is not a loop edge in the directed network model: the network node splits 204b the directed network model at the removed edge.

Then, if the edge is a source edge, the network node adjusts **205a** the directions of relevant edges in the directed network model. If the edge is not a source edge, the network node may end processing relating to the received network event.

The initial identification of loop edges during preprocessing may involve applying graph traversal algorithms capable of detecting cycles, such as: Simple Cycles (D.B. Johnson), Depth-First Search (DFS) for Cycle Detection, Union-Find Algorithm for Cycle Detection, Floyd's Cycle-Finding Algorithm. Similarly, identifying source edges may involve executing pathfinding algorithms (e.g., DFS) between all pairs of nodes designated as power sources within the network model to identify edges forming part of such inter-source paths

Adjusting 204a, 205a the direction of an edge entails modifying the data attribute representing the power flow direction associated with the edge, typically by performing graph traversal algorithms to determine the correct direction for the edge and if relevant, reversing the existing direction of the edge.

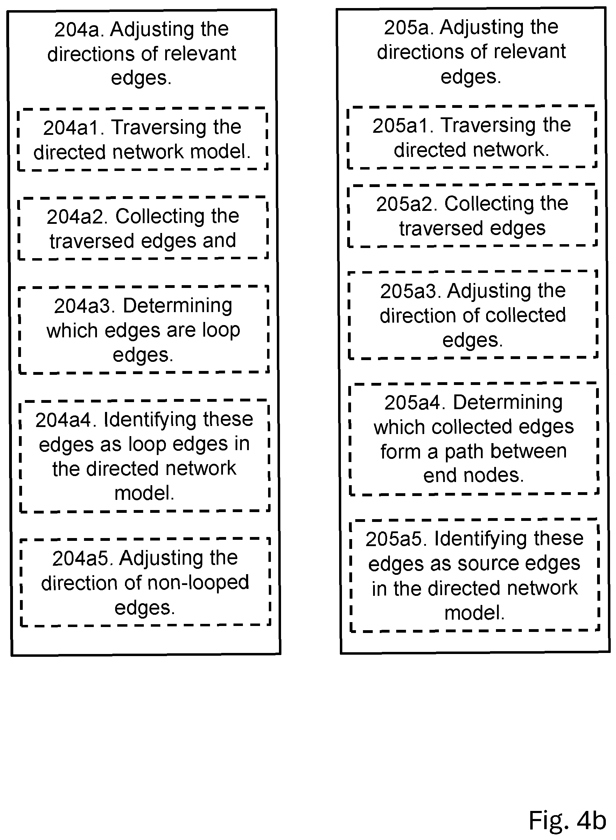

FIG. 4b illustrates embodiments according to the third aspect relating to how the network node may adjust 204a, 205a the relevant edges in the directed network model.

The embodiment to the left in FIG. 4b illustrates how the network node may adjust 204a the direction of relevant edges if the removed edge is a loop edge. This embodiment comprises the following operations:
Traversing **204a1** the directed network model using the edges identified as loop edges, preferably starting from each node associated with the removed edge.

Collecting **204a2** the traversed 204a1 edges.

Determining **204a3** which edges among the collected 204a2 edges are loop edges and identifying **204a5** these edges as loop edges in the directed network model. For example by using a simple cycle graph traversal algorithm to find loop edges among the collected 204a2 edges and associate the looped edges found with the label "loop edge".

The method may additionally adjust the direction of non-loop edges among the collected 204a2 edges. This adjustment may use a graph traversal algorithm to adjust the direction of non-looped edges starting from the traversed nodes connected to at least one edge exclusively associated with an upstream direction.

In one preferred embodiment, the traversed nodes connected to at least one edge exclusively associated with an upstream direction are collected, and the traversal made when determining 204a3 and identifying 205a3 may originate from these collected nodes.

The embodiment to the right in FIG. 4b illustrates how the network node may adjust 205a the direction of relevant edges if the removed edge is a source edge. This embodiment comprises the following operations:
Traversing **205a1** the directed network model using exclusively the edges identified as source edges starting from each node associated with the removed edge until reaching a source node or non-looped source edge.

Collecting **205a2** the traversed 205a1 edges and nodes.

Adjusting **205a3** the direction of non-looped edges among the collected 205a1 edges to upstream.

Determining **205a4** which edges form a path between end nodes among the collected 205a2 traversed edges and nodes (e.g., by employing BSF-based algorithms) and identifying 205a5 these edges as source edges in the directed network model.

The traversal operation 204a1 typically employs a graph search algorithm, such as BFS (Breadth-First-Search) or DFS (Depth-First-Search), initiated from each node endpoint of the removed edge. The search is constrained to explore only along edges currently designated or identified as 'loop edges' within the directed network model. Collecting 204a2, 205a2 involves storing identifiers (or references to the objects themselves) of the edges and nodes encountered during the traversal 204a1, 205a1 into a temporary data structure, like a set or list.

The act of identifying 204a4, 205a4 edges as loop edges or source edges involves assigning or updating a specific attribute, flag, or value associated with the respective edge representations within the data structure of the directed network model. This explicitly marks or designates them as e.g., 'loop edges' following the adjustment process, distinguishing them from non-loop edges.

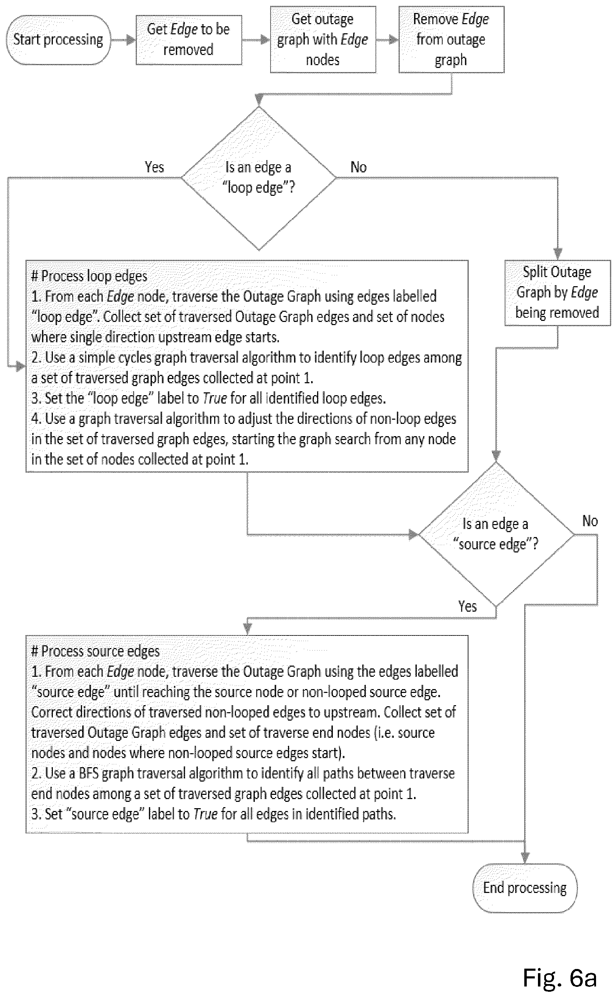

FIG. 6a further illustrates one embodiment according to the third aspect.

### Fourth aspect

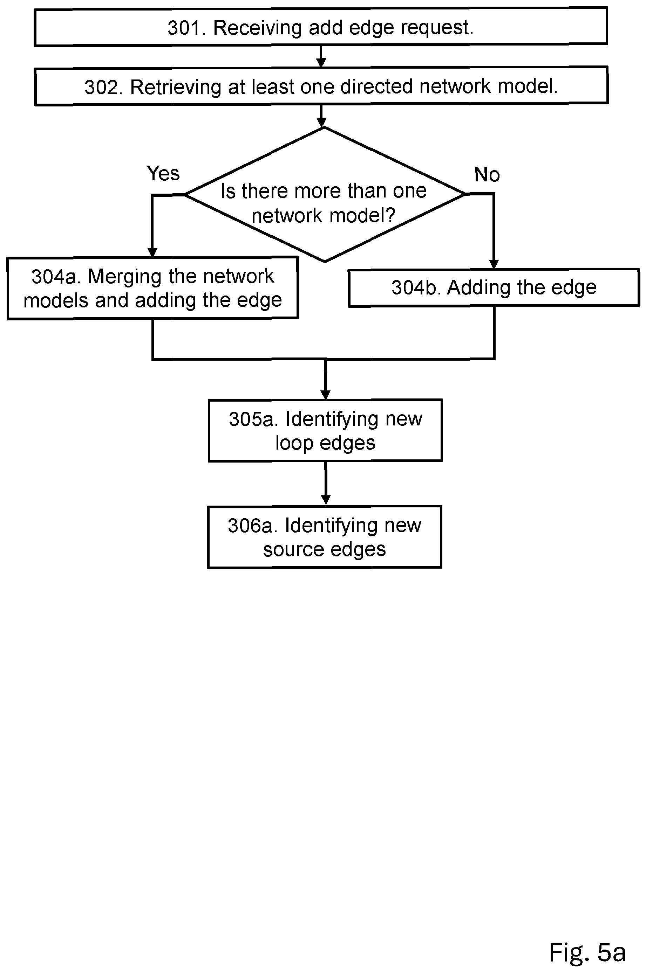

According to a fourth aspect of the present invention there is proposed a method for processing a directed network model reflecting the topology of a power distribution system when handling an edge addition. An embodiment according to the fourth aspect is illustrated in FIG. 5a and comprises the following operations:
Receiving **301** a network event for processing, said event comprising an add edge request. The request specifies unique identification codes (IDs) for two nodes intended to be connected by the new edge.

Retrieving **302** at least one directed network model pertinent to the add edge request. This retrieval targets directed network models containing at least one of the two nodes specified in the request. The retrieved model(s) reflect the topology of the power distribution system, comprising a plurality of nodes and edges, wherein each node represents at least one load or power source, and each edge represents at least one protection device or a power carrying line interconnecting two nodes.

Each directed network model amongst the retrieved 302 model(s) has been preprocessed such that:
- Each edge has been assigned a direction indicating the power flow from a power source towards a load. The concepts of 'upstream' and 'downstream' are defined relative to this directed power flow, consistent with the definitions provided in the context of the third aspect.
- Loop edges and source edges have been identified. A loop edge is part of a cycle (a path starting and ending at the same node without repeating intermediate nodes). A source edge lies on a path interconnecting two or more distinct power source nodes.

The subsequent action depends on the outcome of the retrieving 302 operation:
- If the retrieving 302 operation yields two distinct directed network models (implying the nodes to be connected were previously in electrically separate parts of the modeled system), the method proceeds by **merging 304a** these two models into a single, unified directed network model. Following this, the network node adds the new edge, connecting the two specified nodes within this merged model.
- Conversely, if the retrieving 302 operation yields only one directed network model (indicating the nodes were already within the same modeled electrical section), the network node proceeds directly by adding **304b** the new edge to connect the two specified nodes within that existing model.

Following the adding 304a, 304b of the edge, the method identifies **305a** potential new loop edges engendered by this addition and identifies 306a the new source edges engendered by this addition.

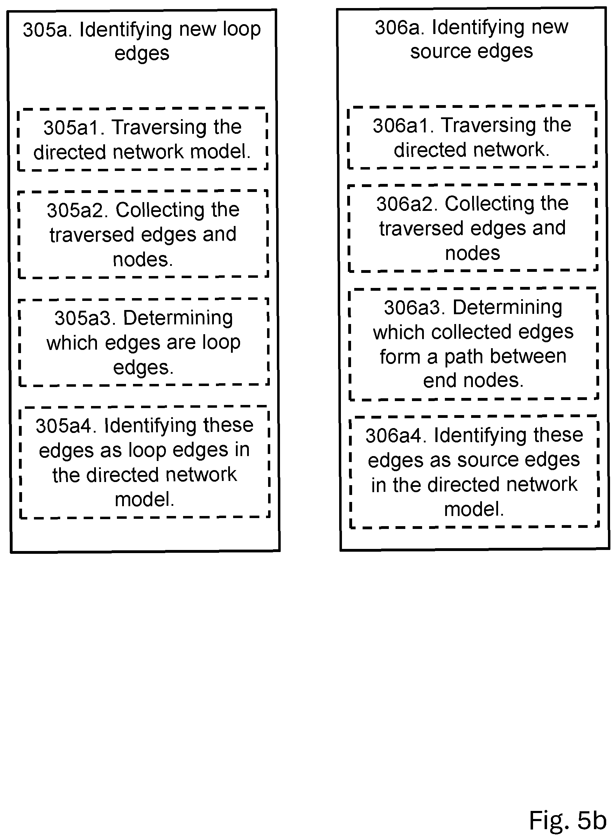

FIG. 5b provides illustrative embodiments detailing the specific operations involved in identifying 305a new loop edges and identifying 306a new source edges.

The embodiment depicted on the left in FIG. 5b illustrates the process of identifying **305a** new loop edges, consequent to the adding 304a, 304b operation. This embodiment comprises:
- Traversing **305a1** the directed network model in the upstream direction, commencing from each of the two nodes associated with the newly added 304a, 304b edge. This traversal continues until at least one node designated as a power source is reached.
- Collecting **305a2** the edges encountered during the traversing 305a1 operation.
- Determining **305a3** which specific edges within the collected 305a2 edges constituting parts of any newly formed loops. This may be determined 305a3 using a simple cycle graph traversal algorithm adapted to distinguish loop edges.
- Identifying 305a4 these determined 305a3 edges explicitly as 'loop edges' within the data representation of the directed network model.

The embodiment depicted on the right in FIG. 5b illustrates the process of identifying 306a new source edges, also consequent to the adding 304a, 304b operation. This embodiment comprises:
- Traversing 306a1 the directed network model in the upstream direction, starting from each node associated with the newly added 304a, 304b edge. This traversal proceeds until reaching either at least one node designated as a power source, or at least one edge previously identified as a source edge (and which is not simultaneously a loop edge).
- Collecting **306a2** both the edges encountered during the traversing 306a1 operation and terminal nodes reached at the conclusion of each traversal path (the 'end nodes").
- Determining **306a3** which paths, if any, can be constructed exclusively using the edges contained within the collected 306a2 edges and nodes, such that these paths interconnect the 'end nodes' also contained within the collected 306a2 edges and nodes. This may be determined 306a3 using graph traversal algorithm.
- Identifying **306a4** every edge that forms part of any such determined 306a3 path explicitly as a 'source edge' within the directed network model's data structure.

The merging 304a operation typically involves combining the node and edge sets of two distinct graph data structures, ensuring consistent identification and resolving any potential namespace conflicts. The adding of an edge involves instantiating a new edge object and associating it with the two specified node objects within the model's data structure.

The traversing operations 305a1, 306a1 necessitate graph search algorithms, such as BFS or DFS search algorithms initiated from the specified nodes and constrained by the upstream directionality and stopping criteria. Collecting 305a2, 306a2 involves accumulating identifiers or references to graph elements in suitable data structures (e.g., lists, sets). Determining 305a3, 306a3 incorporates logic known to the skilled person for cycle detection within the collected edge set (for loop edges) or pathfinding between collected end nodes using only collected edges (for source edges). Identifying 305a4, 306a4, as before, entails updating attributes or flags associated with the edge representations in the model to mark their status as 'loop edge' or 'source edge'.

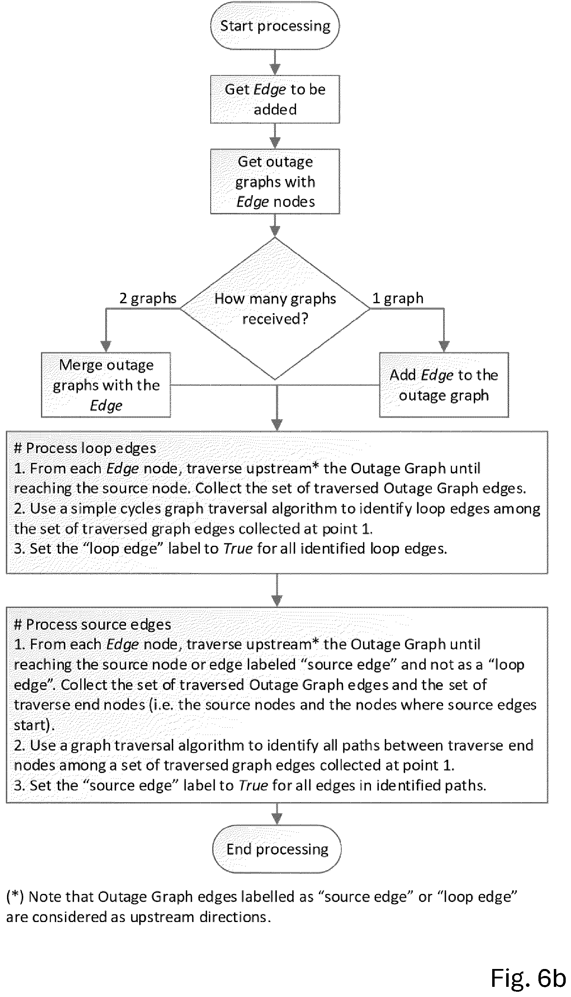

FIG. 6b further illustrates one embodiment according to the fourth aspect.

### Third & fourth aspect

A key advantage conferred by the methods pursuant to the third and fourth aspects resides in the accelerated creation of new directed network models, critically avoiding full preprocessing subsequent to each topological alteration. This efficiency is particularly beneficial for extensive power distribution systems, including architectures managed in a partitioned or distributed manner.

Conventional approaches necessitating complete model generation and full preprocessing impose significant computational latency. In contrast, the present methodologies may operate incrementally upon the saved last version of the created and preprocessed directed network model, thus allowing new directed network models to be created by retrieving existing network models and performing e.g., merging 304a or splitting 204b operations.

This is made possible since a network event 201, 301 triggers targeted, localized updates 204a, 205a, 305a, 306a. Specific operations such as adjusting edge directions 204a, 205a, and re-determining loop 305a or source 306a edge status rely on limited traversals 204a1, 205a1, 305a1, 306a1 confined primarily to affected subgraphs or segments.

In this way, operations like splitting 204b a model or merging 304a models provide efficient mechanisms for recycling previously preprocessed network models.

Consequently, by obviating repeated, computationally burdensome full preprocessing, the described methodologies substantially reduce latency and computational load when creating new models, ensuring the timely availability of an accurate model for subsequent analyses (e.g., problem inference, simulation, load flow) and enhancing overall system scalability.

According to embodiments of the third and/or fourth aspect, the method further comprises subsequent operations relating to the utilization of the processed directed network model.

It should be understood that the processed directed network model refers to the directed network model after having been adjusted according to the method according to the third aspect, fourth aspects or embodiments thereof.

These subsequent operations may comprise utilizing the processed directed network model to performing: power distribution problem inference on the power distribution system; simulating the impact of a proposed sequence of switching operations on the power distribution system; and/or, load flow calculation for the power distribution system.

In one embodiment of the third and/or fourth aspect, the method comprises: receiving sensor data indicative of a potential power distribution problem within the power distribution system; performing a power distribution problem inference analyses utilizing the processed directed network model, wherein the analysis calculates potential fault current paths or analyses network connectivity based at least in part on the identified loop edges and/or source edges to correlate the sensor data with a probable fault location; and outputting data representing the probable power distribution problem location.

According to some embodiments the power distribution problem inference analyses is performed according to the first or second aspect of the present invention.

The dynamic and accurate identification of loop edges and source edges, achieved through the method according to the third or fourth aspect described herein following network topology modifications, provides significant technical advantages for fault location algorithms within an Outage Management System (OMS). By incorporating the up-to-date status of these edges, the fault location analysis can more accurately interpret sensor data (e.g., from protective relays, fault passage indicators, or smart meters). For instance, the knowledge of loop edges allows for correct modeling of parallel fault current paths, while identified source edges enable accurate assessment of fault current contributions from multiple infeeds or potential backfeed conditions. This refined analysis, based on the processed directed network model, leads to a more precise determination of the probable fault location, reducing patrol times for repair crews and accelerating service restoration, thereby directly impacting the operational performance and reliability of the physical power distribution system."

In another embodiment of the third and/or fourth aspect, the method further comprises: receiving at least one network events representing a proposed sequence of switching operations within the power distribution system; simulating the impact of the proposed sequence of switching operations on the power distribution system using the processed directed network model, wherein the simulation predicts power flows, voltages, or loading conditions based at least in part on the identified loop edges and/or source edges resulting from the simulated operations; and generating an output indicative of the technical feasibility or consequences of executing the proposed sequence on the physical power distribution system.

Operational changes in power distribution systems, such as executing switching sequences for maintenance or restoration, require careful planning to avoid adverse effects on the physical grid. The method's ability to provide an up-to-date directed network model, incorporating the correct status of loop and source edges after any topology change, enhances the reliability of planning tools. By simulating proposed switching sequences using this accurate model, operators can predict the technical consequences - such as changes in load flow patterns influenced by newly formed or broken loops (loop edges), or shifts in supply paths due to altered connections between sources (source edges). This simulation allows for the validation of switching plans, ensuring that operations will not lead to component overloads, unacceptable voltage deviations, or unintended islanding within the physical network, thereby contributing directly to operational safety and grid stability.

In yet another embodiment, the method further comprising: performing a load flow calculation (e.g., state estimation) for the power distribution system utilizing the processed directed network model, wherein the calculation uses the identified loop edges to define network admittances and the identified source edges to define power injection points; and using the results of the load flow calculation to generate real-time data representing the operational state of the physical power distribution system for monitoring or control purposes.

Accurate real-time monitoring of the power distribution system state is essential for reliable operation. Load flow calculations and state estimation algorithms, which provide this monitoring capability, are highly sensitive to the accuracy of the underlying network model. The present method ensures that the model, particularly the identification of loop edges (which determine network impedance/admittance) and source edges (which define system inputs), is correctly updated following topological changes. By using this processed directed network model as input, load flow or state estimation algorithms produce more accurate results regarding real-time voltage magnitudes, phase angles, and power flows throughout the physical system. This enhanced accuracy improves situational awareness for grid operators and provides a more reliable basis for automated control actions (e.g., voltage regulation), directly contributing to the stability and efficiency of the physical power distribution system."

### Fifth aspect

Reference is now made to FIG. 3, which illustrates an exemplary embodiment of a system 1000 for managing a power distribution system, according to a fifth aspect of the present invention. The system 1000, which may constitute or be part of an Outage Management System (OMS) or a distribution management system (DMS), comprises an input interface 1010, a memory 1020 (representing a non-transitory computer-readable medium), a processing means 1030 (e.g., one or more processors), and potentially an output interface 1040, all communicatively coupled.

In operation, the input interface 1010 is configured to receive network events pertinent to the power distribution system's topology. These network events may comprise requests for an edge addition or an edge removal between two specified nodes, reflecting physical changes like switch operations or line installations/failures. The input interface 1010 may also be configured to receive sensor data indicative of conditions within the physical power distribution system, such as measurements from SCADA systems, smart meters (AMI), or fault passage indicators.

The processing means 1030 is communicatively coupled to the input interface 1010 and the memory 1020. The memory 1020 stores instructions which, when executed by the processing means 1030, configure the system 1000 to perform the management tasks. Upon receiving a network event via the input interface 1010, the processing means 1030 retrieves or accesses a directed network model, typically stored within memory 1020 or accessible via a database interface. This model reflects the power distribution system's topology, comprising nodes (representing loads, sources, junctions) and edges (representing lines, transformers, protection devices), and includes data identifying pre-existing or previously updated loop edges and source edges, along with edge directions indicative of power flow.

Pursuant to the received network event, the processing means 1030 processes the directed network model. This processing entails executing instructions stored in memory 1020 that implement the methodologies described in the preceding third and fourth aspects. Specifically, the processing means 1030 updates the model structure (adding or removing the specified edge) and then executes graph traversal algorithms originating from the affected nodes. These algorithms re-evaluate connectivity and re-identify which edges in the updated model now qualify as loop edges (part of a cycle) and/or source edges (part of a path between distinct sources), according to the defined criteria. This ensures the model's topological data, particularly the critical loop/source status, remains accurate following the physical network change.

In embodiments according to the fifth aspect, the system 1000 leverages this accurately processed model for further technical purposes. The instructions stored in memory 1020 further cause the processing means 1030 to perform at least one technical analysis related to the physical state or operation of the power distribution system. These analyses explicitly utilize the processed directed network model, incorporating the re-identified loop edges and/or source edges as input parameters.

For example, the technical analysis may comprise performing power distribution problem inference (fault location analysis), such as e.g., defined in the first aspect. Here, the processing means 1030 uses the accurate topology, including loop/source information, to process trouble reports received via the input interface 1010 (e.g., protection trips) and determine which components are should be identified as experiencing a power distribution problem and acted upon.

Alternatively or additionally, the technical analysis may involve simulating the impact of proposed switching operations. The processing means 1030 uses the processed model to predict how executing a sequence of openings/closures (i.e., edge addition or edge removal) would alter power flows, voltages, or protection coordination, considering the network's meshed or multi-source nature as defined by the re-identified loop/source edges.

In another example, the technical analysis may be performing load flow calculations or state estimation. The processing means 1030 uses the accurate topology provided by the processed model, including the loop/source edge status, to compute the current operational state (voltages, flows) of the physical network based on available measurements.

Following the technical analysis, the processing means 1030 generates output data representing the result (e.g., the probable fault location, the simulation outcome, the calculated system state). This output data may be transmitted via the output interface 1040 to other systems, databases, or user displays, providing actionable information for controlling, monitoring, or making operational decisions regarding the physical power distribution system.

This system aspect thus provides a tangible apparatus specifically configured to not only efficiently maintain an accurate topological model in response to dynamic network changes but also to directly apply that enhanced model in performing technical analyses critical for the effective management and operation of the physical power distribution system.

### Definitions:

As used herein, the term "network node" refers to an entity, implemented in hardware, software, or a combination thereof, that is configured to process, exchange, or manage data within a networked environment of a power distribution system. The network node may include one or more computing devices, control units, or communication interfaces / input interfaces and may be operatively coupled to other networked components. The network node may, but need not, comprise, or constitute part of, an outage management system or functions typically associated with an outage management system.

An "Outage Management System" (OMS) is a software application used by utility companies to monitor, manage, and restore electrical service during outages. It integrates various data sources, such as geographic information systems (GIS), supervisory control and data acquisition (SCADA) systems, and customer service databases, to provide real-time information about the status and location of outages. Key features of an OMS may include: visualizing outages and affected areas through mapping tools; and, facilitating the coordination of repair crews and resources to expedite service restoration.

A "Power Distribution System" (PDS) encompasses a network of components that deliver electricity from one or several transmission systems to individual consumers. This system includes various elements such as substations, transformers, distribution lines, and circuit breakers. The key functions and characteristics of a PDS include: reducing high-voltage electricity from the transmission system to a lower voltage suitable for consumer use; and, balancing the demand for electricity among various consumers and implement various protective devices or mechanisms to ensure stability and reliability. The term "power distribution system" may thus consist of one large interconnected transmission system or several independent sub-transmission systems.

For the purposes of this specification, where the terms "power distribution problem," "outage" used interchangeably. The term "power distribution problem" shall be understood to denote an event, state, or condition within or affecting the power distribution network that constitutes, indicates, or directly results in a loss of electrical service continuity to one or more customer service points, and which is typically detected, validated, managed, or resolved using an Outage Management System (OMS). Such power distribution problems, being inherently problematic due to the interruption of service, primarily encompass:
- A complete and sustained loss of power supply (outage) to customer endpoints, particularly unscheduled interruptions arising from faults or equipment failure;
- Events registered by network monitoring (e.g., SCADA protective device operations) or customer interaction systems (e.g., validated customer calls, **AMI** alerts like 'last gasp') that correlate to, or are determined by the OMS to represent, an actual service interruption requiring intervention;
Essentially, within this context, a "power distribution problem" is an actionable service interruption event falling under the management purview of an OMS, triggering its functionalities for location, resource allocation, and restoration coordination.

A "node" represents an entity in the network model corresponding to a power system load, source, or significant junction point.

A "edge" represents a connection between two nodes in the network model, corresponding to a power system component (e.g., line, transformer, protection device) facilitating or controlling power flow.

"Upstream" refers to relative direction in the directed network model towards the supplying power source(s), generally counter to the assigned power flow direction on radial segments. Meaning that e.g., traversal along identified Loop Edges or Source Edges is defined as moving upstream and downstream.

"Downstream" refers to the relative direction in the directed network model opposite to upstream, moving away from source(s) towards loads, generally following assigned power flow on radial segments.

"Loop edge" is an edge identified during preprocessing as part of a cycle (a closed path) within the directed network model, characteristic of meshed topologies. "Source edge" is an edge identified during preprocessing as part of a path connecting two or more distinct power source nodes within the directed network model.

For the purposes of traversals, particularly those aimed at identifying paths towards sources or analysing connectivity within loops or between sources (as pertinent in the third and fourth aspects), traversal in either direction along an edge designated as a "loop edge" or a "source edge" may be considered an "upstream" traversal. This reflects the nature of such edges as potentially forming part of complex paths connecting back to sources or interconnecting multiple sources, where a simple single power flow direction is insufficient to capture the topological relationship relevant for specific analyses like loop or source path identification.

The term "relevant edges" as utilized in the present patent disclosure refers to edges that are relevant to adjust subsequently to an topological change, e.g., a edge removal or addition. Embodiments for determining 204a3, 205a4, 305a3, 306a3 what edges are relevant to adjust are described in embodiments of the aspects disclosed herein.

## Claims

1. A method performed by a network node, comprising:
receiving trouble reports, wherein each trouble report comprises a unique load identification code representing a load in a power distribution system;
for each trouble report, marking the load identification code associated with the trouble report as experiencing a power distribution problem, and adding the marked load identification code to a first dedicated queue Q1
performing a first set of operations for each marked load identification code in the first dedicated queue Q1 comprising the steps:
- retrieving at least one unique protection device identification code each representing a protection device located nearest the marked load identification code in any given direction upstream from the marked load identification code as seen in a directed network model reflecting the topology of the power distribution system; and, for each retrieved protection device identification code:
storing the marked load identification code in a first set S1 associated with the retrieved protection device identification code;
marking a protection device identification code as experiencing a power distribution problem if the protection device identification code fulfills a predetermined criteria set related to at least the first set S1 associated with the protection device identification code;
adding the marked protection device identification code to a second dedicated queue Q2 for further processing; and,
performing a second set of operations for each marked protection device identification code in the second dedicated queue Q2 comprising the steps:
- retrieving at least one unique protection device identification code representing a protection device located nearest the marked protection device identification code in any given direction upstream from the marked protection device identification code as seen in a directed network model reflecting the topology of the power distribution system; and, for each retrieved protection device identification code:
storing the marked protection device identification code in a first set S1 associated with the retrieved protection device identification code.

2. The method according to claim 1, wherein the first set of operations respectively the second set of operations further comprises:
- associating the marked load identification code respectively the marked protection device identification code with a first counter C2 indicating the amount of protection devices and/or loads located nearest the marked load identification code respectively the marked protection device identification code in any given direction downstream as seen in a directed network model reflecting the topology of the power distribution system;
wherein the predetermined criteria set is related to both the first set S1 and first counter C2 associated with the protection device identification code.

3. The method according to any previous claim further comprising:
for each trouble report, adding one count to a trouble report counter C1 associated with each load identification code;
if a trouble report counter is associated with a count above a predetermined threshold, marking the load identification code associated with the trouble report counter as experiencing a power distribution problem, and adding the marked load identification code to a first dedicated queue Q1.

4. The method according to claim 2 further comprising:
marking a protection device identification code as experiencing a power distribution problem if the protection device identification code is associated with a first set S1 and first counter C2 fulfilling at least one condition of the predetermined criteria set, said conditions being fulfilled when:
- the first set S1 having a cardinality of one, and the first counter C2 having a count equal to one,
- the first set S1 having a cardinality equal to a defined threshold, and the first counter C2 having a count greater than one,

5. An outage management system for identifying potential problem locations within a power distribution system, the outage management system comprising:
an input interface configured to receive: i) trouble reports, each trouble report comprising a unique load identification code representing a load in the power distribution system, and ii) data representing a directed network model reflecting the topology and power flow direction within the power distribution system;
a memory configured to store a first dedicated queue (Q1), a plurality of first sets (S1) each associated with a protection device identification code representing protection devices in the power distribution system, and a predetermined criteria set;
a processing means communicatively coupled to the input interface and the memory, the processing means configured to:
- receive said trouble reports via the input interface;
- for each received trouble report, mark the load identification code associated therewith as experiencing a power distribution problem and add the marked load identification code to the first dedicated queue (Q1) stored in the memory;
- perform a first set of operations for each marked load identification code in the first dedicated queue (Q1), said operations comprising: retrieving, based on the directed network model, at least one unique protection device identification code representing a protection device located nearest the marked load identification code upstream, and storing, in the memory, the marked load identification code in the first set (S1) associated with the retrieved protection device identification code;
- mark a protection device identification code as experiencing a power distribution problem if said protection device identification code fulfills the predetermined criteria set stored in the memory, said criteria set being related to at least the first set (S1) associated therewith; and
- generate, based on said marked protection device identification code, an output signal indicative of the identified protection device experiencing the power distribution problem; and
an output interface communicatively coupled to the processing means, configured to transmit said output signal for utilization in managing the power distribution system.

6. The Outage Management System according to claim 5, wherein the processing means are further configured such that the generation of said output signal and its transmission via the output interface comprises performing the steps as recited in any one of claims 1-4.

7. A method for managing a power distribution system comprising:
receiving a network event for processing comprising an edge removal request;
retrieving a directed network model reflecting the topology of the power distribution system, the directed network model includes a plurality of nodes and edges, wherein
each node represents at least one load or power source, and wherein each edge represents at least one protection device or a power carrying line connecting two nodes;
wherein the directed network model has been preprocessed such that:
edges have been assigned directions indicating the direction of power flow from power sources towards loads represented in the network model; wherein upstream direction of an edge is defined as a direction from at least one load to at least one power source, and wherein downstream direction of an edge is defined as a direction from at least one power source to at least one load;
loop edges and source edges are identified, wherein a loop edge is an edge in the directed network model identified as belonging to at least one path that starts and ends at the same node without repeating any intermediate nodes, and wherein a source edge is an edge that is located on at least one path that interconnects two or more nodes representing power sources within the power distribution system;
removing the edge associated with the edge removal request from the directed network model
if the removed edge is a loop edge in the directed network model, adjusting the directions of relevant edges in the directed network model; and, if the removed edge is not a loop edge in the directed network model, splitting the directed network model at the removed edge; and,
if the edge is a source edge, adjusting the directions of relevant edges in the directed network model.

8. The method according to claim 7, further comprising:
if the removed edge is a loop edge in the directed network model, adjusting the directions of relevant edges in the directed network model by:
traversing the directed network model starting from each node associated with the removed edge using exclusively the edges identified as loop edges and collecting the traversed edges;
determining which edges among the collected edges are loop edges and identifying these edges as loop edges in the directed network model; and,
adjusting the direction of non-looped edges among the collected edges.

9. the method according to claim 7 or 8 further comprising:
if the edge is a source edge, adjusting the directions of relevant edges in the directed network model by:
traversing the directed network model starting from each node associated with the removed edge using exclusively the edges identified as source edges until reaching a source node or non-looped source edge and collecting the traversed edges and nodes;
adjusting the direction of collected edges;
determining which edges form a path between end nodes among the collected edges and nodes and identifying these edges as source edges in the directed network model.

10. A method for managing a power distribution system comprising:
receiving a network event for processing comprising an add edge request, wherein said request comprises unique identification codes for two nodes to be connected;
retrieving at least one directed network model comprising at least one node among the two nodes associated with the add edge request, wherein the at least one directed network model reflects the topology of the power distribution system, the at least one directed network model including a plurality of nodes and edges, wherein
each node represents at least one load or power source, and wherein each edge represents at least one protection device or a power carrying line connecting two nodes;
wherein each directed network model among the at least one directed network model has been preprocessed such that:
edges have been assigned directions indicating the direction of power flow from a power source towards a load represented in the directed network model; wherein upstream direction of an edge is defined as a direction from at least one load to at least one power source, and wherein downstream direction of an edge is defined as a direction from at least one power source to at least one load;
loop edges and source edges have been identified, wherein a loop edge is an edge in the directed network model identified as belonging to at least one path that starts and ends at the same node without repeating any intermediate nodes, and wherein a source edge is an edge that is located on at least one path that interconnects two or more nodes representing power sources within the power distribution system;
if the at least one directed network model consists of two directed network models: adding an edge to connect the two nodes associated with the add edge request by merging the two retrieved directed network models to form one directed network model; and, if the at least one directed network model consists of one directed network models, adding an edge to connect the two nodes associated with the add edge request;
processing the directed network model with the added edge to identify new loop edges; and,
processing the directed network model with the added edge to identify new source edges.

11. The method according to claim 10, wherein processing the directed network model with the added edge to identify new loop edges comprises:
traversing the directed network model upstream from each node associated with the added edge until reaching at least one source node and collecting the traversed edges;
determining what edges among the collected edges are loop edges and identifying these edges as loop edges in the directed network model.

12. The method according to claim 10 or 11, wherein processing the directed network model with the added edge to identify new source edges comprises:
traversing the directed network model upstream from each node associated with the added edge until reaching at least one source node and/or at least one source edge which is not a loop edge and collecting the traversed edges and traversed end nodes;
determining what paths are possible to form between the traversed end nodes among the collected edges and nodes using the edges among collected edges and nodes;
identifying each edge forming the determined at least one path as a source edge.

13. A system for managing a power distribution system, comprising:
An input interface configured to receive network events representing changes in topology of the power distribution system and configured to receive sensor data indicative of conditions within the power distribution system;
a processing means communicatively coupled to the input interface; and a non-transitory memory communicatively coupled to the processing means, the memory storing instructions which, when executed by the processing means, cause the system to:
receive, via the input interface, a network event comprising a request for an edge addition or an edge removal between two nodes within a representation of the power distribution system topology;
retrieve or access a directed network model reflecting the topology of the power distribution system, the directed network model comprising a plurality of nodes representing loads or power sources and a plurality of edges representing protection devices or power carrying lines, wherein the directed network model includes data identifying loop edges and source edges;
process the directed network model in response to the received network event according to any of claim 7 to 12.

14. The system according to claim 13, wherein the memory storing instructions which, when executed by the processing means, further causes the system to:
perform a technical analysis related to the physical state or operation of the power distribution system utilizing the processed directed network model, wherein the technical analysis uses the re-identified loop edges and/or source edges as input, the technical analysis comprising at least one of:
(a) performing power distribution problem inference on the power distribution system;
(b) simulating the impact of a proposed sequence of switching operations on the power distribution system;
(c) performing load flow calculation for the power distribution system; and,
generate output data representing a result of the technical analysis for use in controlling or monitoring the power distribution system.
